Europäisches Patentamt

European Patent Office

Office européen des brevets

(11) Veröffentlichungsnummer: **0 278 059 B1**

## (12) EUROPÄISCHE PATENTSCHRIFT

(45) Veröffentlichungstag der Patentschrift: **15.07.92**

(51) Int. Cl.⁵: **B01D 63/00**

(21) Anmeldenummer: **87115733.5**

(22) Anmeldetag: **27.10.87**

(54) Verfahren zur Herstellung eines Filters.

(30) Priorität: **13.02.87 DE 3704546**

(43) Veröffentlichungstag der Anmeldung:
**17.08.88 Patentblatt 88/33**

(45) Bekanntmachung des Hinweises auf die
Patenterteilung:
**15.07.92 Patentblatt 92/29**

(84) Benannte Vertragsstaaten:
**AT CH FR GB IT LI NL SE**

(56) Entgegenhaltungen:
EP-A- 0 270 441
DE-A- 1 810 679
DE-C- 3 631 804

MICROELECTRONIC ENGINEERING, Band 4,
Nr. 1, März 1986, Seiten 35-56, Elsevier
Science Publishers B.V. (North-Holland);
E.W. BECKER et al.: "Fabrication of microstructures with high aspect ratios and great
structural heights by synchrotron radiation
lithography, galvanoforming, and plastic
moulding (LIGA process)"

CHEMICAL ENGINEERING PROGRESS, Band
71, Nr. 12, Dezember 1975, Seiten 55-61; M.C.
PORTER: "Selecting the right membrane"

(73) Patentinhaber: **KERNFORSCHUNGSZENTRUM
KARLSRUHE GMBH**
**Weberstrasse 5 Postfach 3640**
**W-7500 Karlsruhe 1(DE)**

(72) Erfinder: **Ehrfeld, Wolfgang, Dr.**
**Reutstrasse 27**
**W-7500 Karlsruhe 41(DE)**
Erfinder: **Hagmann, Peter, Dr.**
**Nagoldstrasse 9c**
**W-7514 Eggenstein-Leopoldhafen 2(DE)**
Erfinder: **Mohr, Jürgen**
**Hasenstrasse 11**
**W-7519 Sulzfeld(DE)**
Erfinder: **Münchmeyer, Dietrich, Dr.**
**Hagäckerstrasse 5**
**W-7513 Stutensee 3(DE)**

## Beschreibung

Die Erfindung betrifft ein Verfahren zur Herstellung eines Filters mit einer mikroporösen Membran und einer hiermit verbundenen Stützstruktur, bei dem die Membran partiell mit energiereicher Strahlung durchstrahlt und die durchstrahlten Bereiche entfernt werden.

Aus der DE-A-33 32 345 ist ein Feinsieb in Form eines beschichteten Metallgewebes bekannt, bei dem die Beschichtung durch eine die Maschenweite verengende galvanische oder chemische Metallabscheidung gebildet wird. Bei solchen Feinsieben läßt sich das Rückhaltevermögen bzw. die Filterfeinheit durch Kontrolle der Abscheidung steuern und ohne weiteres bis in Bereiche von 0,01 $\mu$m herab ausdehnen und eine definierte Öffnungsweite einstellen. Mit der Verringerung der Maschenweite sinkt allerdings auch die Transparenz des Feinsiebes.

Aus der DE-A-24 40 081 ist ein Filter bekannt mit einem makroporösen Träger, dessen Porendurchmesser etwa 15 bis 20 $\mu$m betragen. Dieser wird nacheinander mit zwei Überzügen beschichtet, deren zweiter einen Porendurchmesser von etwa 1 bis 2 $\mu$m aufweist. Der so behandelte Träger kann dann mit einer mikroporösen Schicht verbunden werden. Ein ähnlich aufgebautes Filter ist in der DE-A-35 46 328 beschrieben; dabei soll die durchschnittliche Porengröße des Substrats zwischen etwa 0,5 $\mu$m und etwa 10 $\mu$m liegen, während die durchschnittliche Porengröße der mikroporösen Membran etwa 0,1 - 1 $\mu$m betragen soll. Bei den Ausführungsbeispielen hatte das Substrat eine Porengröße von 0,9 $\mu$m und die mikroporöse Membran eine solche von etwa 0,08 bis 0,3 $\mu$m. In der DE-A-24 40 081 wird jedoch bereits darauf hingewiesen, daß man versuchen muß, den Durchmesser der Poren der Träger zu vergrößern, ohne den Durchmesser der Poren der mikroporösen Schicht zu vergrößern, um die Qualität der Träger zu verbessern, d.h. ihre Durchlässigkeit zu erhöhen. Andererseits unterliegen bei diesen Filtern die Porengrößen großen statistischen Schwankungen (s.h. Seite 10, Zeilen 3 ff. der DE-A-35 46 328), was das Einhalten enger Toleranzen erschwert.

Aus der Schrift CHEMICAL ENGINEERING PROGRESS, Band 71, Nr. 12, Dezember 1975, Seiten 55-61; M.C. PORTER: "Selecting the right membrane", ist weiter ein Verfahren zur Herstellung einer mikroporösen Membran bekannt, bei dem ein dielektrischer Film mit massiven, energiereichen Kernen durchstrahlt wird. Die dabei entstehenden Kernspuren werden selektiv geätzt, wodurch zylindrische, gerade durchlaufende Poren entstehen. Diese Poren haben eine statistische Verteilung, so daß die erreichbare Porosität derartiger Membranen auf nur 10 % begrenzt ist gegenüber ca. 80 % bei Zellstoffmembranen Ferner ist es aus MICROELECTRONIC ENGINEERING, Band 4, Nr. 1, März 1986, Seiten 35-56, Elsevier Science Publishers B.V. (North-Holland); E.W. BECKER et al.: "Fabrication of microstructures with high aspect ratios and great structural heights by synchrotron radiation lithography, galvanoforming, and plastic moulding (LIGA process)", bekannt, für die Herstellung von Mikrosteckerverbindungen nach dem LIGA-Verfahren nach dem Galvanisieren zum Formen einen Kunststoff zu verwenden, der röntgenstrahlenempfindlich ist. Dies gestattet durch Bestrahlen und Entwickeln des Kunststoffs ein teilweises Freilegen der Metallstruktur, während der verbleibende Kunststoff die Struktur fixiert.

Die Erfindung hat zur Aufgabe, ein Verfahren zur Herstellung eines Filters der gattungsgemäßen Art zu schaffen, das es gestattet, die Verteilung und die Querschnittsform der Poren der mikroporösen Membran sowie die Geometrie der Stützstruktur genau und ohne statistische Schwankungen nach einer frei wählbaren Vorgabe einzuhalten.

Diese Aufgabe wird mit den im Kennzeichen von Anspruch 1 enthaltenen verfahrensmäßigen Maßnahmen gelöst. Anspruch 2 beinhaltet eine erfindungsgemäße Ausgestaltung dieser Lösung.

Die mit dem erfindungsgemäßen Verfahren hergestellten Filter zeichnen sich durch eine extrem hohe Regelmäßigkeit bezüglich ihrer Geometrie aus, ohne daß hierbei eine Verminderung der Transparenz in Kauf genommen werden muß. Die Geometrie der Stützstruktur kann unabhängig von der Art der mikroporösen Membran hinsichtlich des gegenseitigen Abstandes der Stützelemente sowie deren Höhe und Breite in optimaler Weise an die jeweiligen anwendungsspezifischen Anforderungen, z.B. in bezug auf den Strömungswiderstand oder die mechanische Festigkeit, angepaßt werden.

Unabhängig hiervon lassen sich die Mikroporen entsprechend den jeweiligen filtertechnischen Anforderungen in die Membran einbringen, obwohl die Membran und die Stützstruktur ein integrales Bauelement bilden.

Das Verfahren wird im folgenden anhand der Figuren 1 bis 9 beispielhaft erläutert, wobei sich die Figuren 1 bis 4 auf die Herstellung einer Form für die Stützstruktur, die Figuren 5 und 6 auf das Ausformen der Form für die Herstellung der Membran und der Stützstruktur und die Figuren 7 und 8 auf die Herstellung der Poren in der Membran durch partielles Durchstrahlen der Membran und durch Entfernen der Bereiche mit einer erhöhten Löslichkeit beziehen. In Figur 9 ist eine weitere Ausführungsform für die Stützstruktur der Membran dargestellt.

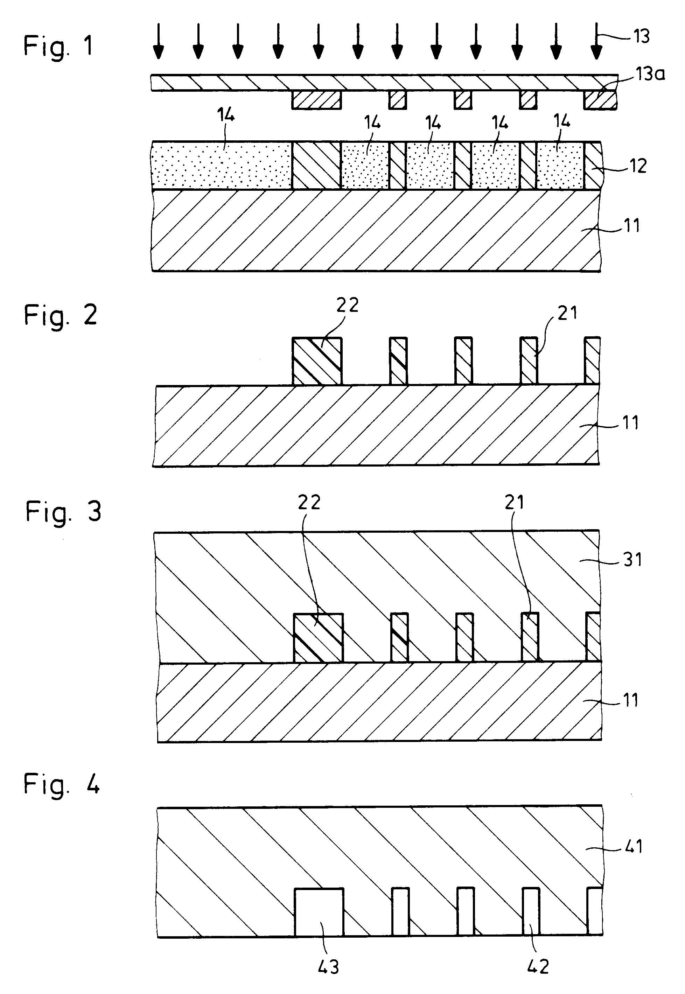

In Figur 1 bedeutet 11 eine plattenförmige Galvanikelektrode, mit der eine Schicht 12 aus durch energiereiche Strahlung in seiner Löslichkeit veränderbarem Material (Positiv-Resistmaterial) verbunden ist. Durch partielles Durchstrahlen mit Röntgenstrahlung 13 über eine Maske 13a und Entfernen des Resistmaterials in den durchstrahlten Bereichen 14 unter Ausnutzung der durch die Strahlung in diesen Bereichen erhöhten Löslichkeit werden Formen 21 (Fig. 2) für die Stützelemente der Stützstruktur sowie Formen 22 für eine Randverstärkung erzeugt, die mit der Galvanikelektrode 11 verbunden sind. In einem Galvanikbad wird auf der Galvanikelektrode 11 eine über die Formen 21 und 22 hinauswachsende und diese Formen vollständig einschließende Galvanikschicht 31 (Fig. 3) erzeugt. Nach Entfernen der Galvanikelektrode 11 und der Formen 21 und 22 aus der Galvanikschicht 31 verbleibt eine Form 41 (Fig. 4) mit Hohlräumen 42, 43 für die Stützelemente der Stützstruktur und die Randverstärkung.

Die Galvanikelektrode 11 läßt sich durch Auflösen entfernen, wobei für ihre Herstellung ein Material verwendet wird, das sich in einem Lösungs- oder Ätzmittel auflöst, welches die Galvanikschicht 3l nicht angreift. Das Entfernen der Galvanikelektrode 11 gelingt auch ohne ihre Zerstörung durch vorsichtiges Abziehen der Galvanikschicht 31 von der Galvanikelektrode 11, wenn die Haftfestigkeit der Galvanikschicht 31 in bekannter Weise durch entsprechende Vorbehandlung, z.B. durch Passivierung der Galvanikelektrode 11, vermindert worden ist.

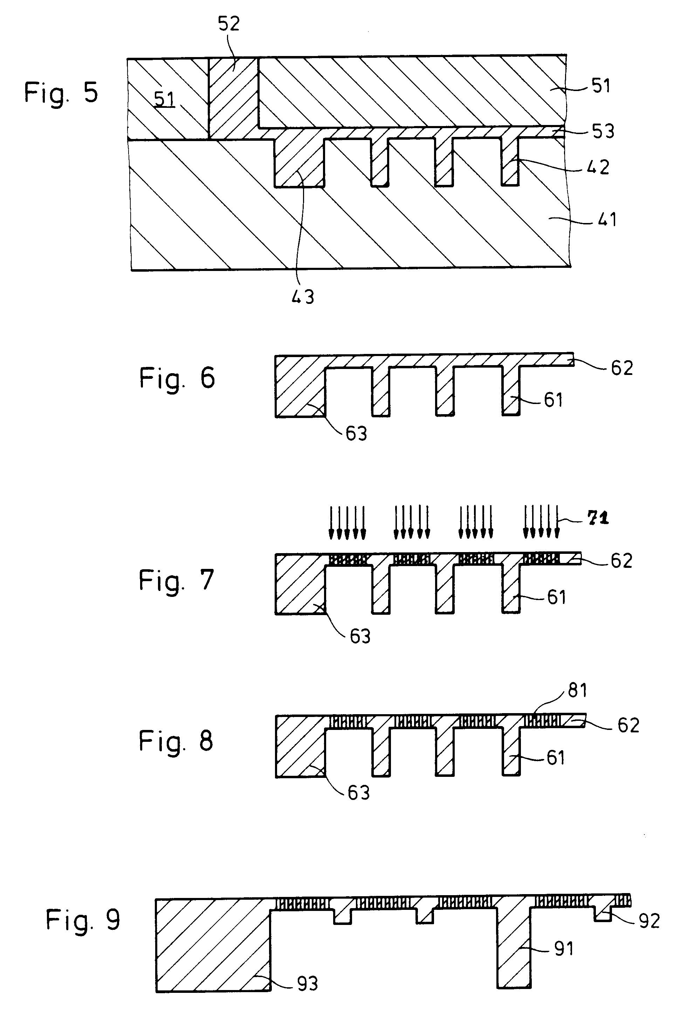

In Fig 5 bedeutet 51 eine Abdeckplatte, die mit einer Aussparung 53 und Angußbohrungen 52 versehen ist. Nach dem Aufeinanderpressen der Abdeckplatte 51 und der Form 41 in der dargestellten Position wird durch die Aussparung 53 in der Abdeckplatte und durch die Hohlräume 42, 43 eine Form für die Membran und die Stützstruktur erzeugt. Über die Angußbohrungen 52 wird eine Abformmasse aus durch energiereiche Strahlung in seiner Löslichkeit veränderbatem Material in die Form für die Stützstruktur und die Membran gefüllt und dort verfestigt, wobei sich ein durch Röntgenstrahlung in seiner Löslichkeit veränderbarer Formstoff bildet.

Nach dem Verfestigen der Abformmasse erfolgt die Entformung und das Entfernen des Angusses, d.h. der in der Angußbohrung 52 verfestigten Abformmasse, so daß eine Membran 62 mit den hiermit fest verbundenen Stützelementen 61 der Stützstruktur und der Randverstärkung 63 erhalten werden (Fig. 6). Durch partielles Durchstrahlen der Membran 62 mit Röntgenstrahlung 71 (Fig. 7) und anschließendes Entfernen der durchstrahlten Bereiche mit erhöhter Löslichkeit (Fig. 8) werden in der Membran 62 nach einer vorgegebenen Verteilung und Querschnittsform Mikroporen 81 erzeugt. Die Bestrahlung erfolgt über eine Röntgenmaske, die für die Röntgenstrahlung nach einem Muster, das der Verteilung und Querschnittsform der Mikroporen entspricht, durchlässig ist. Die Stützelemente 61 der Stützstruktur können beispielsweise bei gleicher Höhe lamellenartig oder auch wabenförmig angeordnet sein. Die Stützstruktur kann auch nach mechanischen und strömungstechnischen Gesichtspunkten anwendungsspezifisch optimiert und beispielsweise, wie in Fig. 9 dargestellt, aus hohen und breiten Stützelementen 91 bzw. Randverstärkungen 93 und niederen und dünneren Elementen 92, ähnlich wie bei Leichtbauwerkstoffen, aufgebaut sein. Bei einer solchen Anordnung wird die Entformung erleichtert, da die besonders dünnen Elemente 92 auch nur eine geringe Höhe haben.

Die so hergestellten Membranen mit Poren und integrierten Stützstrukturen können selbstverständlich auch als Träger für eine weitere mikroporose Membran verwendet werden.

Der Abstand zwischen parallel verlaufenden Wänden der Stützelemente beträgt z.B. 80 $\mu$m bei einer Wandstärke von ca. 20 $\mu$m. Die Porenweite der mikroporösen Membran kann unabhängig hiervon 0,2 bis 2 $\mu$m betragen bei sehr engem gegenseitigem Abstand und einer Membrandicke von ca. 5 $\mu$m Die Höhe der Stützelemente kann bis zu 500 $\mu$m betragen. Als Material für die Galvanikelektrode kann man z.B. Kupfer verwenden und als Material für die galvanisch hergestellte Form z.B. Nickel. Selbstverständlich läßt sich die Form auch mit anderen bekannten Fertigungsverfahren, wie z.B. Senkerodieren, herstellen.

Als Abformmasse wird bevorzugt ein Gießharz auf Methacrylatbasis verwendet, dem ein internes Trennmittel zur Erleichterung der Entformung zugesetzt wird. Das bei der Verfestigung der Abformmasse sich bildende Polymethylmethacrylat (PMMA) ist ein Formstoff, der die Eigenschaften eines Positiv-Resistmaterials aufweist.

**Patentansprüche**

1. Verfahren zur Herstellung eines Filters mit einer mikroporösen Membran (62) und einer hiermit verbundenen Stützstruktur (61, 63), bei dem die Membran (62) partiell mit energiereicher Strahlung (71) durchstrahlt und die durchstrahlten Bereiche entfernt werden, gekennzeichnet durch folgende Schritte:

a) Herstellen einer Form (41, 51) für die Membran (62) und die Stützstruktur (61, 63);
b) Ausformen der Form (41, 51) mit einem durch die energiereiche Strahlung in seiner Löslichkeit veränderbaren Formstoff und Entformen des aus Membran und Stützstruktur bestehenden Bauelements (61, 62, 63);

c) Durchführen des partiellen Durchstrahlens (71) der Membran (62) nach einem Muster, das einer vorgebbaren Verteilung und Querschnittsform der Mikroporen (81) entspricht.

2. Verfahren nach Anspruch 1, dadurch gekennzeichnet, daß für das Ausformen der Form (41, 51) ein Positiv-Resistmaterial verwendet wird und daß die partielle Durchstrahlung mit Röntgenstrahlung über eine Röntgenmaske erfolgt.

## Claims

1. Method of producing a filter with a microporous diaphragm (62) and a supporting structure (61, 63), which is associated therewith, wherein the diaphragm (62) is partially irradiated with energy-rich radiation (71), and the irradiated regions are removed, characterised by the following steps:

   a) producing a mould (41, 51) for the diaphragm (62) and the supporting structure (61, 63);

   b) filling the mould (41, 51) with a moulding substance, which is variable in respect of its solubility by the energy-rich radiation, and removing from the mould the constructional element (61, 62, 63), which comprises the diaphragm and supporting structure;

   c) effecting the partial irradiation (71) of the diaphragm (62) in accordance with a pattern which corresponds to a prescribable distribution and cross-sectional form of the micropores (81).

2. Method according to claim 1, characterised in that a positive resist material is used to fill the mould (41, 51), and in that the partial irradiation with X-radiation is effected via the intermediary of an X-ray mask.

## Revendications

1. Procédé de fabrication d'un filtre avec une membrane microporeuse (62) et une structure d'appui (61, 63) qui lui est liée, dans lequel on irradie partiellement la membrane (62) avec un rayonnement énergétique (71) et on élimine les zones irradiées, procédé caractérisé par les étapes suivantes :

   a) fabrication d'un moule (41, 51) pour la membrane (62) et la structure d'appui (61, 63),

   b) démoulage du moule (41, 51) avec une substance de moulage à solubilité modifiable par le rayonnement énergétique et démoulage de l'élément constitutif (61, 62, 63) comprenant la membrane et la structure d'appui,

   c) réalisation de l'irradiation partielle (71) de la membrane (62) selon un modèle qui correspond à une répartition et une forme de section des micropores (81) pouvant être prédéfinies.

2. Procédé selon la revendication 1, caractérisé en ce que pour réaliser le moule (41, 51), on utilise un matériau résiste positif et que l'irradiation partielle aux rayons X se fait par l'intermédiaire d'un masque de rayons X.

Fig. 1

Fig. 2

Fig. 3

Fig. 4

Fig. 5

52
51
51
53
42
41
43

Fig. 6

62
61
63

Fig. 7

71
62
61
63

Fig. 8

81
62
61
63

Fig. 9

92
91
93